# FASCICULE DE BREVET EUROPEEN

(11) **EP 0 616 419 B1**
(45) Date de publication et mention de la délivrance du brevet: **04.02.1998**
(21) Numéro de dépôt: 94410016.3
(22) Date de dépôt: 16.03.1994
(51) Int. Cl.: H03B 28/00

(54) **Générateur multifréquence programmable**
Programmierbarer Mehrfrequenzgenerator
Programmable multi-frequency generator

(30) Priorité: 17.03.1993 FR 9303329
(43) Date de publication de la demande: 21.09.1994
(73) Titulaire: SGS-THOMSON MICROELECTRONICS S.A., 94250 Gentilly (FR)
(72) Inventeur: Fensch, Thierry, F-38000 Grenoble (FR); Mazoyer, Yves, F-38100 Grenoble (FR)
(74) Mandataire: de Beaumont, Michel

(56) Documents cités:
- US-A- 4 422 155
- US-A- 4 631 694
- ELECTRONICS LETTERS, vol.22, no.12, 1986, STEVENAGE GB pages 635 - 636 SANDLER AND SENDRA : 'Sine-wave generation using a high-order lowpass switched-capacitor filter.'

## Description

La présente invention telle qu'elle est définie dans les revendications concerne les générateurs de signal sinusoïdal à fréquence programmable destinés, par exemple, à fournir un son par des programmations successives de la fréquence du signal, ou à fournir une superposition de sinusoïdes de fréquences distinctes par une programmation simultanée de plusieurs générateurs dont on somme les sorties.

Les générateurs de signal sinusoïdal programmables sont utilisés en particulier dans des postes téléphoniques pour générer les mélodies de sonnerie ou les signaux DTMF (Dual Tone Modulation Frequency) qui résultent de la superposition de deux sinusoïdes de fréquences distinctes mais voisines.

Le document US-A-4 631 694 décrit un générateur de signal sinusoïdal.

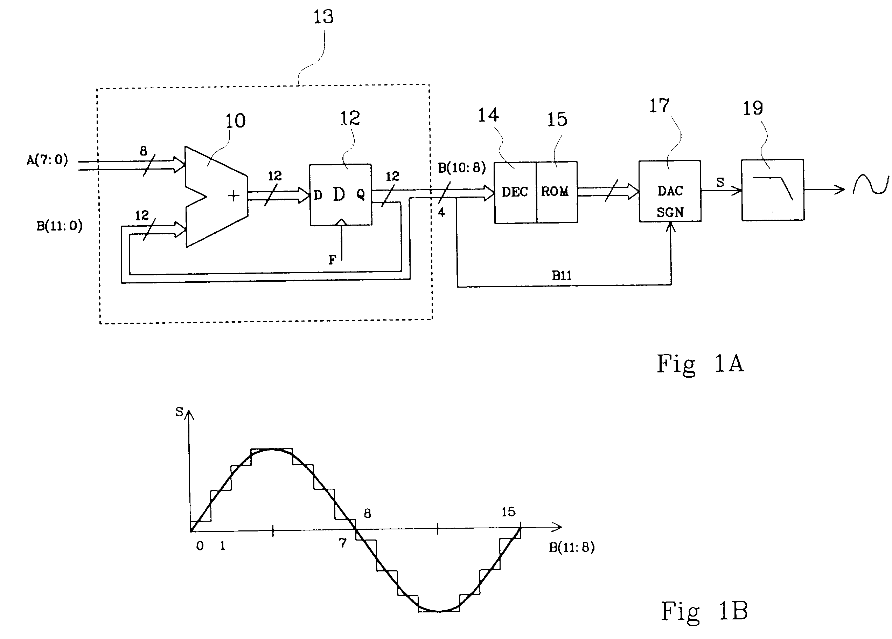

La figure 1A représente schématiquement un générateur de signal sinusoïdal à fréquence programmable utilisé dans des postes téléphoniques classiques. Ce générateur oomprend un additionneur 10 pour additionner un mot de programmation A de 8 bits et un mot de retour B de 12 bits. La sortie de l'additionneur 10 est fournie à l'entrée d'une bascule 12 de type D cadencée par un signal d'horloge F. Le mot de retour B est fourni par la sortie de la bascule 12.

Avec une telle configuration, les 4 bits de poids le plus fort (B8 à B11) du mot B oscillent à des fréquences proportionnelles à la valeur du mot A et à la fréquence du signal d'horloge F. En outre, les états des bits B8 à B11 varient de manière à réaliser un comptage en binaire. Ainsi, l'additionneur 10 et la bascule 12 constituent un compteur à 4 bits à fréquence de comptage programmable, ou bien un générateur 13 de signal rectangulaire à fréquence programmable (la sortie de ce générateur 13 pouvant être l'un quelconque des bits B8 à B11).

Les bits B8 à B11 forment un mot B(11:8) fourni à un décodeur 14 qui sélectionne une valeur correspondante dans une mémoire morte (ROM) 15 (avec 4 bits, dans le présent exemple, on peut sélectionner 16 valeurs distinctes). La sortie de la mémoire ROM 15, la valeur sélectionnée, est fournie à l'entrée d'un convertisseur numérique/analogique 17 dont la sortie S, filtrée par un filtre passe-bas 19, fournit le signal sinusoïdal à générer.

La figure 1B montre l'allure du signal S généré grâce au circuit de la figure 1A. Le signal S présente une valeur discrète pour chaque valeur du mot B(11:8), ces valeurs discrètes étant convenablement choisies pour correspondre à des valeurs successives d'une période de sinusoïde.

Pour économiser de la mémoire, on ne stocke dans la mémoire ROM que les valeurs correspondant à un quart de période de sinusoïde, les 4 premières valeurs dans le présent exemple. Le décodeur 14 est prévu, à l'aide des 3 premiers bits B8 à B10 du mot B(11:8), pour sélectionner ces 4 premières valeurs successivement par ordre croissant puis par ordre décroissant au fur et à mesure de l'incrémentation du mot B(11:8). Le dernier bit B11 du mot B(11:8) est fourni au convertisseur 17 pour intervertir le signe du signal S pendant que sont fournies les valeurs discrètes correspondant à chaque deuxième alternance de sinusoïde.

Le signal S présente 16 valeurs discrètes par période et une fréquence égale à celle du signal B11. Un tel signal S génère des harmoniques que le filtre 19 est supposé supprimer. Or la fréquence de coupure du filtre 19 est fixe, ce qui entraîne que cette fréquence doit être choisie égale à la fréquence la plus élevée à générer. Ainsi, quand on génère des fréquences basses par rapport à la fréquence de coupure, un grand nombre d'harmoniques n'est pas atténué, ce qui entraîne un son désagréable à l'écoute. Il n'est pas envisageable avec un tel générateur de commander un haut-parleur piézoélectrique qui a l'avantage d'être particulièrement peu coûteux, mais qui a tendance à entrer en résonance avec des harmoniques, et donc à accentuer ces harmoniques.

Bien entendu, si l'on veut diminuer le nombre d'harmoniques générés à basse fréquence, on peut augmenter le nombre de valeurs discrètes fournies par période de sinusoïde. Toutefois, cela entraîne qu'il faut augmenter la capacité de l'additionneur 10 et de la mémoire ROM 15, ce qui devient coûteux si l'on veut atténuer les harmoniques à basse fréquence de manière sensible.

En outre, le filtre 19 n'est pas intégrable car il nécessite une ou plusieurs capacités de valeur trop importante pour pouvoir les intégrer.

Un objet de la présente invention est de prévoir un générateur de signal sinusoïdal programmable qui génère un signal présentant un faible nombre d'harmoniques quelle que soit sa fréquence.

Un autre objet de la présente invention est de réaliser un tel générateur qui offre un compromis surface/performance meilleur que les générateurs classiques.

Un autre objet de la présente invention est de réaliser un tel générateur qui soit en outre entièrement intégrable.

Un autre objet de la présente invention est de réaliser un tel générateur qui soit utilisable avec un haut-parleur de faible coût sans désagréments d'écoute.

Ces objets sont atteints grâce à un générateur d'une sinusoïde à fréquence programmable comprenant un générateur de signal rectangulaire à fréquence programmable ; un moyen de comptage des périodes dudit signal rectangulaire ; un moyen de décodage pour fournir des valeurs discrètes successives de sinusoïde à partir des états successifs du moyen de comptage ; un filtre passe-bas recevant les valeurs discrètes successives de sinusoïde et fournissant la sinusoïde. Selon l'invention, le filtre passe-bas est un filtre à capacités commutées dont la commutation est commandée par un signal de fréquence proportionnelle à la fréquence du signal rectangulaire, d'où il résulte, par un choix adéquat des valeurs des capacités du filtre, que la fréquence de coupure du filtre est toujours voisine de la fréquence de la sinusoïde.

Selon un mode de réalisation de la présente invention, le filtre reçoit une tension d'entrée constante. Le moyen de décodage comprend une capacité commutée de valeur programmable pour régler le gain du filtre, cette capacité programmable étant formée par une pluralité de capacités dont chacune est mise en ou hors circuit par un interrupteur commandé par un décodeur de l'état du moyen de comptage.

Selon un mode de réalisation de la présente invention, le moyen de comptage comprend un compteur à plusieurs bits, recevant ledit signal rectangulaire, le bit de poids le plus fort servant à commander l'inversion ou non du signe du gain du filtre, et les autres bits étant fournis au décodeur.

Selon un mode de réalisation de la présente invention, la capacité commutée programmable est comprise dans une cellule de commutation dans laquelle l'une des bornes de la capacité commutée programmable est susceptible d'être reliée, par un commutateur commandé par ledit bit de poids le plus fort, à des interrupteurs rendant ladite cellule non-inverseuse, ou à des interrupteurs rendant ladite cellule inverseuse.

Selon un mode de réalisation, le générateur génère une pluralité de sinusoïdes superposées de fréquences voisines programmables et comprend un filtre à capacités commutées fournissant les sinusoïdes superposées, commandé à une fréquence proportionnelle à la plus élevée des fréquences programmables. Le générateur comprend, pour chaque sinusoïde, un générateur de signal rectangulaire, un moyen de comptage, un moyen de décodage et une capacité commutée programmable par le moyen de décodage.

Ces objets, caractéristiques et avantages ainsi que d'autres de la présente invention seront exposés en détail dans la description suivante de modes de réalisation particuliers faite en relation avec les figures jointes parmi lesquelles :
la figure 1A, précédemment décrite, représente un générateur de signal sinusoïdal programmable classique ;
la figure 1B représente un exemple d'allure de signal sinusoïdal généré avant son filtrage par le générateur de la figure 1A ;
la figure 2 représente un mode de réalisation schématique d'un générateur de signal sinusoïdal programmable selon l'invention ;
la figure 3 représente en détail un autre mode de réalisation de générateur de signal sinusoïdal programmable selon l'invention ;
les figures 4A et 4B représentent en détail deux éléments du générateur de la figure 3 ; et
la figure 5 représente un mode de réalisation d'un générateur selon l'invention de plusieurs sinusoïdes superposées de fréquences distinctes programmables.

Dans les figures, des mêmes éléments sont désignés par des mêmes références.

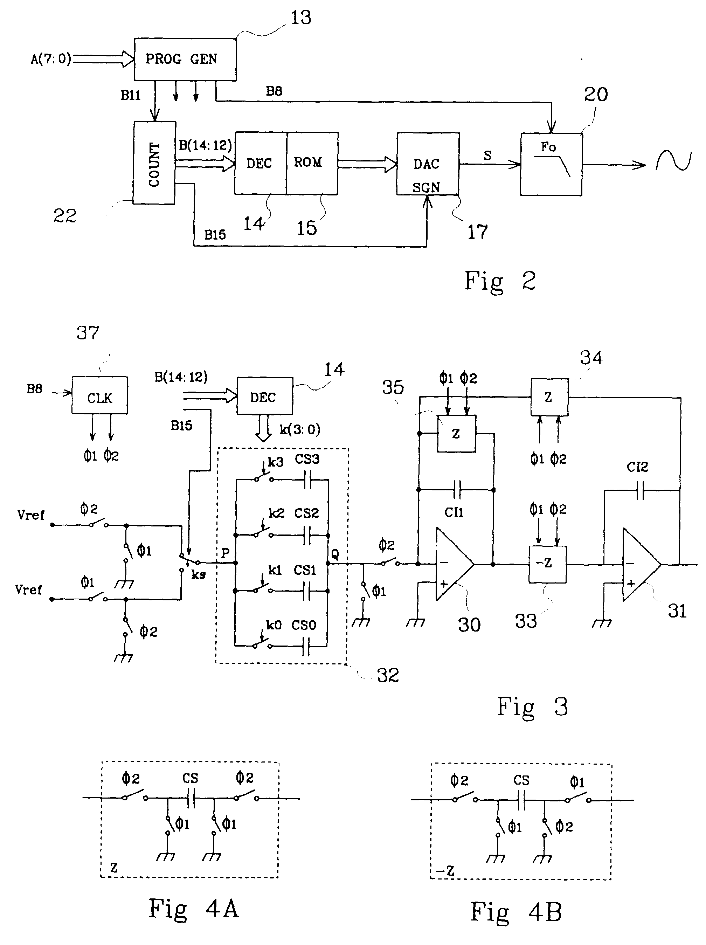

A la figure 2, on retrouve le générateur 13 de signaux rectangulaires à fréquence programmable, le décodeur 14 associé à la mémoire ROM 15, et le convertisseur numérique/analogique 17.

Selon l'invention, le signal de sortie S du convertisseur 17 est filtré par un filtre à capacités commutées 20 dont la fréquence de commande, ou fréquence d'échantillonnage, est proportionnelle à la fréquence du signal sinusoïdal à générer. Ainsi, la fréquence de coupure F₀ du filtre à capacités commutées 20 est proportionnelle à la fréquence du signal sinusoïdal. Les éléments du filtre 20 sont choisis pour que cette fréquence de coupure F₀ soit légèrement supérieure à la fréquence du signal sinusoïdal.

On choisit comme signal de commande du filtre 20 un signal fourni par le générateur programmable 13. Pour que le filtre 20 fonctionne correctement, il faut que la fréquence de son signal de commande soit grande par rapport à la fréquence du signal S à filtrer, qui est sensiblement égale à la fréquence de coupure F₀. Pour cela, parmi les signaux B8 à B11 fournis par le générateur 13, on choisit comme signal de commande le signal B8, dont la fréquence est la plus élevée. En outre, plutôt que de fournir les sorties du générateur programmable 13 directement au décodeur 14, le signal de sortie B11, dont la fréquence est la plus basse, est fourni à un compteur 22. Le compteur 22 permet de fournir des valeurs au décodeur 14 à une fréquence suffisamment faible par rapport à la fréquence de commande du filtre 20. Dans le présent exemple, avec un compteur 22 à quatre bits B12 à B15, on obtient un rapport suffisant de 128 entre la fréquence du signal de commande B8 et la fréquence du signal B15 qui est celle du signal généré.

Les signaux B12 à B15 jouent les mêmes rôles, respectivement, que les signaux B8 à B11 du circuit de la figure 1A. On obtient, dans l'exemple décrit, un signal S avant filtrage présentant l'allure de la figure 1B et la fréquence du signal B15.

Puisque la fréquence de coupure du filtre 20 est toujours voisine de la fréquence du signal S à filtrer, les harmoniques du signal S subissent une importante atténuation. Cette atténuation est d'autant plus importante que l'ordre du filtre 20 est élevé. En choisissant un filtre du deuxième ordre et 16 valeurs dans une période de sinusoïde, on obtient des résultats tout à fait satisfaisants.

Le signal sinusoïdal généré peut directement alimenter un haut-parleur de faible coût (par exemple piézoélectrique) sans que celui-ci soit susceptible d'entrer en résonance avec des harmoniques, et donc de générer des bruits désagréables.

En outre, le choix selon l'invention d'un filtre à capacités commutées entraîne que le générateur programmable selon l'invention est entièrement intégrable, car les capacités du filtre peuvent être choisies à des valeurs très faibles (seuls les rapports entre capacités entrent en compte dans un filtre à capacités commutées).

La figure 3 représente un autre mode de réalisation de générateur de signal sinusoïdal à fréquence programmable selon l'invention, dans lequel un filtre à capacités commutées 20 est représenté en détail. Ce mode de réalisation permet avantageusement d'éviter l'emploi d'une mémoire ROM 15 et d'un convertisseur numérique/analogique 17, ce qui rend le générateur selon l'invention particulièrement économique.

Le filtre à capacités commutées est un filtre du deuxième ordre comprenant une section de filtrage comportant deux amplificateurs opérationnels 30 et 31 et, selon un aspect de l'invention, une section de réglage de gain 32 comprenant un réseau de capacités CS0 à CS3, ci-après capacités de gain, mises en ou hors circuit par des interrupteurs respectifs k0 à k3. L'entrée du filtre reçoit une tension de référence constante Vref et les valeurs discrètes de la sinusoïde à générer sont obtenues par le décodeur 14 qui, grâce aux interrupteurs k0 à k3, sélectionne des gains correspondants du filtre. Ces aspects sont décrits plus en détail ultérieurement.

Les amplificateurs opérationnels 30 et 31 sont montés en inverseurs. Une capacité d'intégration CI1 relie la sortie de l'amplificateur 30 à son entrée, et une capacité d'intégration CI2 relie la sortie à l'amplificateur 31 à son entrée. La sortie de l'amplificateur 31 fournit le signal sinusoïdal généré. La sortie de l'amplificateur 30 est couplée à l'entrée de l'amplificateur 31 par une cellule à capacité commutée inverseuse (-Z) 33. La sortie de l'amplificateur 31 est couplée à l'entrée de l'amplificateur 30 par l'intermédiaire d'une cellule à capacité commutée non-inverseuse (Z) 34. Une cellule à capacité commutée non-inverseuse 35 est reliée en parallèle sur la capacité d'intégration CI1.

Chacune des cellules 33 à 35 est commandée par deux signaux d'horloge, respectivement ^{c}1 et ^{c}2. Ces signaux d'horloge sont fournis par un générateur d'horloge 37 à partir du signal B8 fourni par le générateur programmable 13. Comme cela est connu de la technique, les signaux ^{c}1 et ^{c}2 sont de fréquence égale à celle du signal B8 mais présentent des niveaux actifs non-chevauchants pour commuter des interrupteurs en opposition de phase de manière que ces interrupteurs ne soient pas simultanément fermés lors des commutations. Ci-après, un interrupteur commandé par un signal ^{c}1 ou ^{c}2 sera appelé interrupteur ^{c}1 ou ^{c}2, respectivement.

La section de réglage de gain 32 du filtre comprend les capacités de gain CS0 à CS3 qui peuvent chacune être mise en série entre un noeud d'entrée P et un noeud de sortie Q par l'interrupteur respectif k0 à k3. Les interrupteurs k0 à k3 sont commandés par le décodeur 14 d'une manière adéquate, décrite ultérieurement. Le noeud Q est relié à l'entrée de l'amplificateur 30 par un interrupteur ^{c}2 et à une tension de référence, par exemple la masse, par un interrupteur ^{c}1. Le noeud P peut être relié à la tension de référence Vref par l'intermédiaire de l'une ou l'autre de deux branches selon la position d'un commutateur kS. La première branche (celle correspondant à la position représentée de l'interrupteur kS) relie le noeud P à la tension Vref par un interrupteur ^{c}2 et à la masse par un interrupteur ^{c}1. La deuxième branche relie le noeud P à la tension Vref par un interrupteur ^{c}1 et à la masse par un interrupteur ^{c}2.

Lorsque la première branche est sélectionnée, on trouve entre la tension Vref et l'entrée de l'amplificateur 30 une cellule à capacité commutée non-inverseuse, la capacité commutée étant la ou les capacités de gain sélectionnées par les interrupteurs k0 à k3. Lorsque la deuxième branche est sélectionnée, cette même cellule devient inverseuse. Ainsi, la position du commutateur kS détermine le signe du signal de sortie du filtre. Ce commutateur kS est commandé par le signal B15.

Le gain du filtre est égal au rapport entre la valeur de la capacité de la cellule 34 et la valeur de la capacité de gain selectionnée. Ainsi, on génère chaque valeur discrète de sinusoïde en sélectionnant une ou plusieurs capacités de gain, les valeurs des capacités de gain ayant été choisies adéquatement à la fabrication. La sélection des capacités de gain peut se faire de deux manières qui déterminent des valeurs différentes à choisir pour ces capacités. On peut sélectionner une seule des capacités à la fois, ou bien en sélectionner une première au départ et successivement mettre en parallèle les autres sur la première.

On a représenté 4 capacités de gain CS0 à CS3, ce qui permet d'obtenir 4 valeurs discrètes d'une demi alternance de sinusoïde, et donc 16 valeurs discrètes d'une période de sinusoïde. Le décodeur 14 est réalisé pour, à partir des 3 signaux B12 à B14, par exemple sélectionner successivement les capacités de gain dans l'ordre CS0 à CS3, puis dans l'ordre CS3 à CS0, le commutateur kS étant basculé après chacun de ces cycles par le signal B15.

Les figures 4A et 4B représentent respectivement une cellule à capacité commutée non-inverseuse Z et une cellule à capacité commutée inverseuse -Z.

Dans la figure 4A, chaque borne d'une capacité CS est reliée à la masse par un interrupteur ^{c}1 et reliée à la sortie ou à l'entrée de la cellule par un interrupteur ^{c}2.

Dans la figure 4B, les positions des interrupteurs associés à l'une des bornes d'une capacité CS sont interverties par rapport à celles de la figure 4A.

Tous les éléments de la figure 3 sont intégrables et occupent une faible surface de silicium par rapport à un générateur utilisant une mémoire ROM et un convertisseur numérique/analogique.

La présente invention s'applique aussi à la génération de signaux sinusoïdaux différentiels. Pour cela, on emploie des amplificateurs opérationnels 30, 31 à sorties différentielles, et les éléments décrits en relation avec la figure 3 sont dupliqués pour chaque voie différentielle.

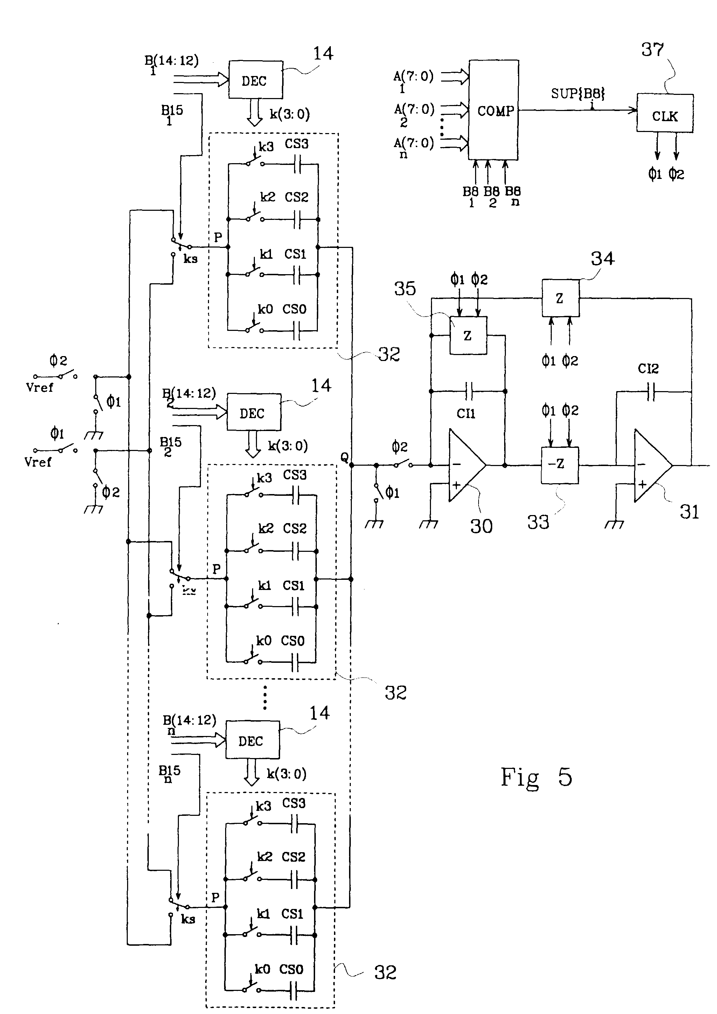

La figure 5 représente un mode de réalisation d'un générateur de plusieurs sinusoïdes superposées de fréquences distinctes programmables. Ce générateur comprend, à la place de l'interrupteur kS et de la section de réglage de gain 32 de la figure 3, une pluralité d'interrupteurs kS et sections de réglage de gain 32 disposés en parallèle. A chaque section de réglage 32 est associé un décodeur 14 et un compteur (non représenté) fournissant au décodeur des bits Bᵢ12 à Bᵢ14 et au commutateur kS associé un bit Bᵢ15 (i= 1, 2...n). A chacun de ces compteurs est bien entendu associé un générateur programmable 13 (non représenté) fournissant des bits Bᵢ8 à Bᵢ11 dont la fréquence de commutation est fixée par un mot de programmation Aᵢ(7:0).

Avec cette configuration, l'unique section de filtrage reçoit une succession de paliers correspondant à plusieurs sinusoïdes discrétisées superposées.

Comme cela est représenté, le circuit d'horloge 37 servant à cadencer les commutateurs ^{c}1 et ^{c}2 est commandé par le signal de fréquence la plus élevée parmi les signaux B₁8, B₂8... Bₙ8, ce signal, noté Sup#Bᵢ8§, étant fourni par un circuit 38.

Le circuit 38 reçoit chacun des mots de programmation Aᵢ(7:0) et chacun des signaux Bᵢ8. Il détermine le plus grand des mots Aᵢ(7:0) et aiguille sur sa sortie le signal Bᵢ8 correspondant.

Avec un tel système, la fréquence de coupure du filtre à capacité commutée est réglée à la fréquence la plus élevée des sinusoïdes générés. Ainsi, les sinusoïdes de fréquence plus basse présenteront une distorsion plus élevée que les sinusoïdes de fréquence plus élevée. Toutefois, si le rapport des fréquences extrêmes ne dépasse pas environ 1,5, la distorsion reste tout à fait acceptable.

Un tel circuit est particulièrement adapté, dans un poste téléphonique, à générer des signaux DTMF (Dual Tone Modulation Frequency) qui sont formés par la superposition de deux sinusoïdes de fréquences proches.

Des détails supplémentaires concernant la réalisation de filtres à capacités commutées, notamment le choix des valeurs des capacités pour régler la fréquence de coupure du filtre peuvent être trouvés dans l'ouvrage intitulé "Design of MOS VLSI Circuits for Telecommunications" par Tsividis-Antognettis, Editions Prentice-Hall, Angleterre.

De nombreuses variantes et modifications de la présente invention apparaîtront à l'homme du métier, notamment en ce qui concerne le choix du type de filtre à capacités commutées, du nombre de capacités de réglage de gain ainsi que leur mode de commande. D'autres choix de disposition des capacités de réglage de gain sont possibles, par exemple en série les unes avec les autres avec leur interrupteur respectif disposé en parallèle.

## Revendications

1. Générateur d'au moins une sinusoïde à fréquence programmable comprenant :
- au moins un générateur (13) de signal rectangulaire à fréquence programmable ;
- au moins un moyen de comptage (12, 22) des périodes dudit signal rectangulaire ;
- au moins un moyen de décodage (14, 15, 32) pour fournir des valeurs discrètes successives de sinusoïde à partir des états successifs dudit au moins un moyen de comptage ;
- un filtre passe-bas (20) recevant les valeurs discrètes successives de sinusoïde dudit au moins un moyen de décodage et fournissant ladite au moins une sinusoïde ;
caractérisé en ce que le filtre passe-bas est un filtre à capacités commutées dont la commutation est commandée par un signal (B8) de fréquence proportionnelle à la fréquence dudit signal rectangulaire, d'où il résulte, par un choix adéquat des valeurs des capacités du filtre, que la fréquence de coupure du filtre est toujours voisine de la fréquence de ladite au moins une sinusoïde.

2. Générateur d'au moins une sinusoïde selon la revendication 1, caractérisé en ce que le filtre reçoit une tension d'entrée constante (Vref) et en ce que le moyen de décodage comprend une capacité commutée de valeur programmable pour régler le gain du filtre, cette capacité programmable étant formée par une pluralité de capacités (CS0-CS3) dont chacune est mise en ou hors circuit par un interrupteur (k0-k3) commandé par un décodeur (14) de l'état du moyen de comptage.

3. Générateur d'au moins une sinusoïde selon la revendication 2, caractérisé en ce que le moyen de comptage comprend un compteur (22) à plusieurs bits, recevant en entrée ledit signal rectangulaire (B11), le bit de poids le plus fort (B15) servant à commander l'inversion ou non du signe du gain du filtre, et les autres bits étant fournis audit décodeur.

4. Générateur d'au moins une sinusoïde selon la revendication 3, caractérisé en ce que la capacité commutée programmable est comprise dans une cellule de commutation dans laquelle l'une des bornes de la capacité commutée programmable est susceptible d'être reliée, par un commutateur (kS) commandé par ledit bit de poids le plus fort (B15), à des interrupteurs rendant ladite cellule non-inverseuse, ou à des interrupteurs rendant ladite cellule inverseuse.

5. Générateur d'une pluralité de sinusoïdes superposées de fréquences voisines programmables selon la revendication 4, caractérisé en ce qu'il comprend un filtre à capacités commutées fournissant les sinusoïdes superposées et commandé à une fréquence proportionnelle à la plus élevée desdites fréquences programmables, et en ce qu'il comprend, pour chaque sinusoide, un générateur de signal rectangulaire, un moyen de comptage, un moyen de décodage et une capacité commutée programmable par le moyen de décodage.

## Patentansprüche

1. Generator zur Erzeugung wenigstens einer Sinuswelle mit programmierbarer Frequenz, der Generator umfassend
- wenigstens einen Generator (13) zur Erzeugung eines Rechtecksignals mit programmierbarer Frequenz,
- wenigstens eine Zählvorrichtung (12, 22) zur Zählung der Perioden des genannten Rechtecksignals,
- wenigstens eine Dekodiervorrichtung (14, 15, 32) zur Bildung aufeinanderfolgender diskreter Sinuswellen-werte ausgehend von aufeinanderfolgenden Zuständen der genannten wenigstens einen Zählvorrichtung,
- ein Tiefpaßfilter (20), dem die aufeinanderfolgenden diskreten Sinuswellen-Werte der genannten wenigstens einen Dekodiervorrichtung zugeführt werden und das die genannte wenigstens eine Sinuswelle bildet,
**dadurch gekennzeichnet**
daß das Tiefpaßfilter ein Filter mit geschalteten Kondensatoren ist, deren Umschaltung durch ein Signal (B8) einer zur Frequenz des genannten Rechtecksignals proportionalen Frequenz gesteuert wird, derart daß sich durch geeignete Wahl der jeweiligen Größen der Filterkondensatoren ergibt, daß die Grenzfrequenz des Filters stets benachbart der Frequenz der genannten wenigstens einen Sinuswelle ist.

2. Generator zur Erzeugung wenigstens einer Sinuswelle nach Anspruch 1, dadurch gekennzeichnet, daß das Filter eine konstante Eingangsspannung (Vref) zugeführt erhält und daß die Dekodiervorrichtung einen geschalteten Kondensator programmierbarer Größe zur Regelung bzw. Einstellung des Filterverstärkungsfaktors aufweist, wobei diese programmierbare Kapazität von mehreren Kondensatoren (CS0 - CS3) gebildet wird, deren jeder durch einen Umschalter (k0 - K3) ein- bzw. ausgeschaltet wird, der durch einen Dekoder (14) für den Zustand der Zählvorrichtung gesteuert wird.

3. Generator zur Erzeugung wenigstens einer Sinuswelle nach Anspruch 2, dadurch gekennzeichnet, daß die Zählvorrichtung einen Mehr-Bit-Zähler (22) aufweist, der als Eingangsgröße das genannte Rechtecksignal (B11) zugeführt erhält, wobei das Bit (15) mit dem höchsten Stellenwert zur Steuerung der Inversion oder Nicht-Inversion der Filterverstärkung dient und die anderen Bits dem genannten Dekoder zugeführt werden.

4. Generator zur Erzeugung wenigstens einer Sinuswelle nach Anspruch 3, dadurch gekennzeichnet, daß der programmierbare geschaltete Kondensator in einer Umschaltzelle enthalten ist, in welcher einer der Anschlüsse des programmierbaren geschalteten Kondensators mittels einem durch das genannte höchstrangige Bit (B15) gesteuerten Umschalter (kS) mit Umschaltern, welche die genannte Zelle invertierend machen, oder mit Umschaltern, welche die genannte Zelle nichtinvertierend machen, verbunden werden kann.

5. Generator zur Erzeugung mehrerer überlagerter Sinuswellen mit programmierbaren benachbarten Frequenzen, nach Anspruch 4, dadurch gekennzeichnet, daß er ein Filter mit geschalteten Kondensatoren aufweist, welches die überlagerten Sinuswellen liefert und mit einer zur höchsten der genannten programmierbaren Frequenzen proportionalen Freqzenz gesteuert ist, und daß er für jede Sinuswelle einen Rechtecksignalgenerator, eine Zählvorrichtung, eine Dekodiervorrichtung und einen durch die Dekodiervorrichtung programmierbaren geschalteten Kondensator aufweist.

## Claims

1. A generator for producing at least one programmable frequency sine wave signal, including:
- at least one square-wave signal programmable frequency generator (13);
- at least one means (12, 22) for counting the periods of said square-wave signal;
- at least one decoding means (14, 15, 32) for providing successive discrete sine wave values from successive states of said at least one counting means;
- a low-pass filter (20) receiving the successive discrete sine wave values from said at least one decoding means and providing said at least one sine wave;
characterized in that said low-pass filter (20) is a switched-capacitor filter whose switching mode is controlled by a signal (B8) having a frequency proportional to the frequency of said square-wave signal, whereby, by switably selecting the values of the filter's capacitors, the cut-off frequency of the filter is always in the vicinity of the frequency of said at least one sine wave.

2. The sine wave generator of claim 1 wherein the filter receives a constant input voltage (Vref) and wherein the decoding means includes a switched capacitor having a programmable value to set the filter gain, said programmable capacitor being formed by a plurality of capacitors (CS0-CS3), each of which is switched on or off by a switch (k0-k3) controlled by a decoder (14) decoding the state of the counting means.

3. The sine wave generator of claim 2 wherein the counting means includes a multi-bit counter (22), receiving as an input said square-wave signal (B11), the most significant bit (B15) serving to control the inversion or non-inversion of the sign of the filter's gain, and the remaining bits being provided to said decoder.

4. The sine wave generator of claim 3 wherein the programmable switched capacitor is contained in a switch cell in which one of the terminals of the programmable switched capacitor is connectable, through a switch (kS) controlled by the most significant bit (B15), to switches to put the cell in non-inversion mode, or to switches to put the cell in inversion mode.

5. A generator for generating a plurality of superposed sine waves having close frequencies which are programmable according to claim 4, characterized in that it includes a switched-capacitor filter that provides the superposed sine waves and is controlled at a frequency that is proportional to the highest of said programmable frequencies, and in that it includes, for each sine wave, a square-wave signal generator counting means, decoding means and a switched capacitor that is programmable by the decoding means.
